# EUROPEAN PATENT SPECIFICATION

(11) **EP 3 020 848 B1**
(45) Date of publication and mention of the grant of the patent: **11.07.2018**
(21) Application number: 15192897.5
(22) Date of filing: 04.11.2015
(51) Int. Cl.: C23C 14/02, C23C 14/32, C23C 14/35, C23C 14/50, C23C 14/16, H01F 41/02, C23C 14/22

(54) **A VACUUM COATING DEVICE FOR SURFACE COATING OF SMALL SIZED ND-FE-B MAGNETS AND A CORRESPONDING VACUUM COATING METHOD**
VAKUUMBESCHICHTUNGSVORRICHTUNG ZUR OBERFLÄCHENBESCHICHTUNG VON KLEINSTÜCKIGEN ND-FE-B-MAGNETEN UND ENTSPRECHENDES VAKUUMBESCHICHTUNGSVERFAHREN
DISPOSITIF D'APPLICATION DE REVÊTEMENT SOUS VIDE POUR UN REVÊTEMENT DE SURFACE À AIMANTS ND-FE-B DE PETITE TAILLE ET PROCÉDÉ DE REVÊTEMENT SOUS VIDE CORRESPONDANT

(30) Priority: 05.11.2014 CN 201410612086
(43) Date of publication of application: 18.05.2016
(73) Proprietor: Yantai Shougang Magnetic Materials Inc., 265500 Yantai (CN)
(72) Inventor: Yang, Kunkun, 265500 Yantai City (CN); Peng, Zhongjie, 265500 Yantai City (CN); Jia, Daoning, 265500 Yantai City (CN)
(74) Representative: Gulde & Partner

(56) References cited:
- CN-A- 103 839 641
- JP-A- 2000 133 541
- JP-A- 2011 216 674
- JP-B2- 4 540 076
- US-A1- 2002 028 631
- US-B2- 8 480 815

## Description

The invention mainly relates to a surface anticorrosion technology for Nd-Fe-B magnets. In particular, the invention deals about a vacuum coating method on the surface of small sized Nd-Fe-B magnets.

### Technological Background

Due to the potential difference between the Nd-rich phase and Nd₂Fe₁₄B phase, and possible hydrogen absorption, an Nd-Fe-B magnet is very easily to corrode. Generally, anticorrosive coatings are disposed on the surface of Nd-Fe-B magnets for corrosion protection. The common ways of preparation of Nd-Fe-B magnet surface anticorrosion coatings include electrophoresis, spraying, vacuum coating and electroplating.

JP 2011-216674 A and CN 103839641 A disclose exemplary embodiments of vacuum coating devices useful for coating of rare earth permanent magnets as well as corresponding coating processes. The coating devices include a vacuum furnace chamber and a plurality of drums with mesh sidewall being rotatable arranged inside the chamber for accommodation of the magnets to be coated. There is further provided a target source for vacuum deposition within the chamber. During the coating process the drums are rotated under low pressure argon atmosphere. An aluminum film may be deposited on the surface of the magnets.

For small sized Nd-Fe-B magnets it is difficult to fix the magnet samples with common fixtures during the coating process.

### Summary of Invention

The invention aims to overcome the shortage of the existing technologies and provides a method of vacuum coating on the surface of small sized Nd-Fe-B magnets as defined in claim 1.

In a first process step of the vacuum coating method, there is provided a vacuum coating device for surface coating of small sized Nd-Fe-B magnets. The device comprises:
- a vacuum furnace chamber;
- a drum with mesh sidewalls being rotatable arranged on a rotary shaft inside the vacuum furnace chamber;
- at least one target source for vacuum deposition being arranged within the vacuum furnace chamber;
- a gas inlet for connecting an argon source; and
- an outlet for connecting a vacuum system.

The vacuum furnace chamber may have cylindrical main body.

The drum may include stirring elements being arranged inside the drum. The stirring elements may preferably have isosceles triangle or trapezoid shape. The drum may be made of stainless steel.

The rotary shaft can be connected with a driving machine in order to rotate the drum with a predetermined rotational speed.

The at least one target source may be provided at a sidewall of the vacuum furnace chamber. The target source may be composed of aluminum or an aluminum alloy.

The method including the following process steps:
a) providing a vacuum coating device as defined before;
b) putting small sized Nd-Fe-B magnet samples together with steel balls into a drum of the vacuum coating device and evacuating the drum until the pressure is 6 x 10⁻³ Pa to 9 x 10⁻³ Pa;
b) starting rotation of the drum and mixing the Nd-Fe-B magnet samples and steel balls, the drum rotational speed is 5 to 20 r/min (rounds per minute);
c) injecting argon gas until the pressure is 3x 10⁻¹ Pa to 6 × 10⁻¹ Pa; and
d) starting vacuum coating.

A thickness, length and width of the Nd-Fe-B magnet samples is less than 15 mm. In particular, a three direction difference is less than 10 mm.

A diameter Φ of the steel balls is 2 mm to 6 mm and a weight is 0.25 to 1.5 times of the weight of the Nd-Fe-B magnet samples.

Vacuum coating may preferably performed by arc ion plating or magnetron sputtering.

The inventive coating method may be used for preparation of a metal film layer. In particular, the metal layer may be composed of at least one of aluminum, copper, titanium, terbium, dysprosium, neodymium or alloys thereof. Most preferred is the coating of aluminum.

The inventive vacuum coating device has a simple structure, low limitations with regard to the shape of the magnet sample and ensures high efficiency of the coating process. The inventive coating method avoids harm coating conditions, which occur e.g. in conventional spry coating procedures.

### Brief Description of the Drawings

- Figure 1: is a schematic illustration of a vacuum coating device according to the present invention;
- Figure 2: is a cross-sectional side view of Figure 1;
- Figure 3: is a photographic illustration of magnet samples being coated by the inventive process; and
- Figure 4: is a microscopic a photographic illustration of a coating film on a magnet sample.

### Detailed Description of the Invention

The invention will now be described in detailed embodiments, which should not be construed to be limiting.

### Example 1

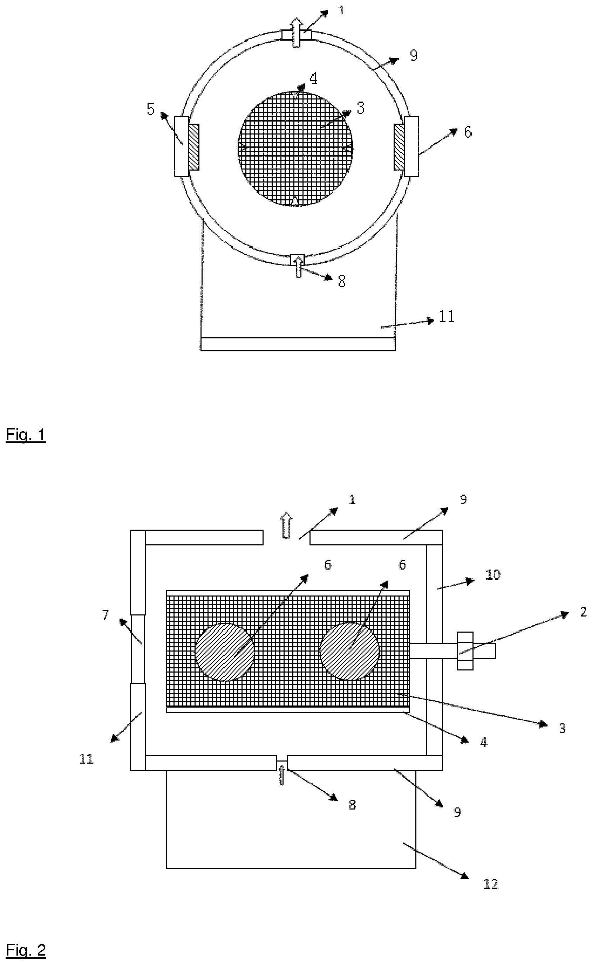

A vacuum coating device, which may be useful for vacuum surface coating of small sized magnets, will now be described in detail with reference to Figures 1 and 2. Said device comprises:
- a vacuum furnace chamber 10 including a cylindrical main body 9. One sidewall of the furnace chamber 10 includes an observation window 7 and a door 11;
- a drum 3 with mesh sidewalls made of steel and being rotatable arranged on a rotary shaft 2 inside the vacuum furnace chamber 10. The rotary shaft 2 extends through another sidewall of the vacuum furnace chamber 10 in sealed manner. The rotary shaft is connected to a driving machine (not shown) in order to rotate the drum 3 with a predetermined rotational speed. The drum 3 includes stirring elements 4 of isosceles triangle shape;
- four target sources 5, 6 for vacuum deposition are positioned on opposite sides of the cylindrical main body 9 of the vacuum furnace chamber 10. The target sources 5, 6 consist of aluminum;
- a gas inlet 8 for connecting an argon source is provided on a lower part of the vacuum furnace chamber 10;
- an outlet 1 is provided for connecting a vacuum system (not shown) with the vacuum furnace chamber 10; and
- the vacuum furnace chamber 10 is mounted on a chassis 12.

Aluminum vacuum surface coating of small sized Nd-Fe-B magnets is performed as follows:
2 kg of small sized Nd-Fe-B magnets (size of 7 mm x 1.46 mm x 0.85 mm) and 3 kg steel balls with 2 mm diameter are put into the drum. When the vacuum reaches 8.5 x 10⁻³ to 9 x 10⁻³ Pa, drum rotation starts (rotation speed 20 r/min). The rotation of the drum 3 will ensure a uniform coating process. Evacuation is continued until the pressure is 3 to 3.5 x 10⁻³ Pa. The argon gas inlet valve is opened such that the pressure is 5.5 to 6 x 10⁻¹ Pa. Then the deposition process starts and the target material acts as aluminum arc ion source. During the deposition process voltage is 20 V and current 60 A for 30 min.

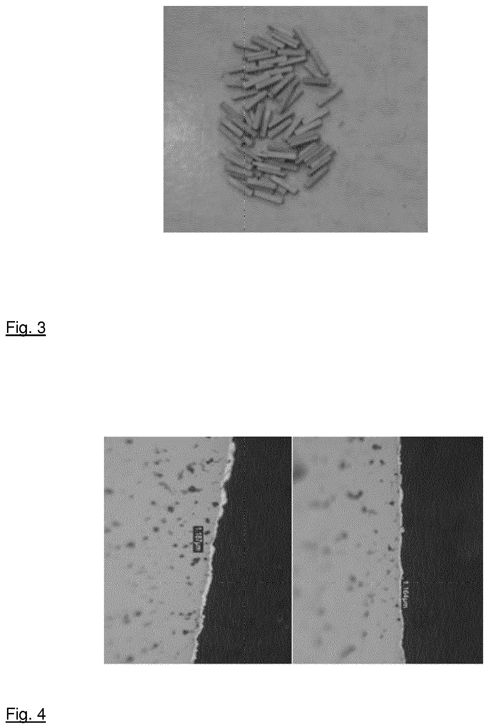

Figure 3 shows a picture of Nd-Fe-B magnets, which are aluminum coated by the before mentioned process. Figure 4 is a microscopic picture of the aluminum surface of one of the Nd-Fe-B magnets. As can be seen from the pictures, the sample surface is quite smooth and the aluminum layer has uniform thickness.

### Example 2

The process is performed with the same coating device as used in Example 1.

2 kg of small sized Nd-Fe-B magnets (size of 8 mm x 6 mm x 8 mm) and 0.5 kg steel balls with 6 mm diameter are put into the drum. When the vacuum reaches 6 to 6.5 x 10⁻³ Pa, drum rotation starts (rotation speed 15 r/min). The rotation of the drum 3 will ensure a uniform coating process. Evacuation is continued until the pressure is 5.5 to 6 x 10⁻³ Pa. The argon gas inlet valve is opened such that the pressure is 3 to 3.5 x 10⁻¹ Pa. Then the deposition process starts and the target material acts as aluminum arc ion source. During the deposition process voltage is 20 V and current 60 A for 60 min.

## Claims

1. A vacuum surface coating method of small sized Nd-Fe-B magnets, the method including the following process steps:
a) providing a vacuum coating device comprising:
- a vacuum furnace chamber (10);
- a drum (3) with mesh sidewalls being rotatable arranged on a rotary shaft (2) inside the vacuum furnace chamber (10);
- at least one target source (5, 6) for vacuum deposition being arranged within the vacuum furnace chamber (10);
- a gas inlet (8) for connecting an argon source; and
- an outlet (1) for connecting a vacuum system;
b) putting small sized Nd-Fe-B magnet samples together with steel balls into a drum (3) of the vacuum coating device and evacuating the drum (3) until the pressure is 6 x 10⁻³Pa to 9 x 10⁻³Pa, wherein thickness, length and width of the Nd-Fe-B magnet samples are less than 15 mm and a three direction difference thereof is less than 10 mm, and wherein a diameter Φ of the steel balls is 2 mm to 6 mm and a weight is 0.25 to 1.5 times of the weight of the Nd-Fe-B magnet samples;
b) starting rotation of the drum (3) and mixing the Nd-Fe-B magnet samples and steel balls, the drum rotational speed is 5 to 20 r/min;
c) injecting argon gas until the pressure is 3x 10⁻¹ Pa to 6 × 10⁻¹ Pa; and
d) starting vacuum coating.

2. The method of claim 1, wherein vacuum coating is performed by arc ion plating or magnetron sputtering.

3. The method of claim 1, wherein vacuum coating includes the deposition of aluminum on the Nd-Fe-B magnet samples.

## Patentansprüche

1. Vakuum-Oberflächenbeschichtungs-Verfahren für kleinstückige Nd-Fe-B-Magnete, wobei das Verfahren die folgenden Verfahrensschritte aufweist:
a) Bereitstellen einer Vakuumbeschichtungsvorrichtung, umfassend:
- eine Vakuumofenkammer (10);
- eine Trommel (3) mit Gitterseitenwänden, die drehbar auf einer Drehwelle (2) in der Vakuumofenkammer (10) angeordnet sind;
- mindestens eine Targetquelle (5, 6) zur Vakuumabscheidung, die innerhalb der Vakuumofenkammer (10) angeordnet ist;
- einen Gaseinlass (8) zum Anschluss einer Argonquelle; und
- einen Auslass (1) zum Anschluss eines Vakuumsystems;
b) Zusammenlegen kleinstückiger Nd-Fe-B-Magnetproben mit Stahlkugeln in eine Trommel (3) der Vakuumbeschichtungsvorrichtung und Evakuieren der Trommel (3), bis der Druck 6×10⁻³ Pa bis 9×10⁻³ Pa beträgt, wobei die Dicke, Länge und Breite der Nd-Fe-B-Magnetproben weniger als 15 mm beträgt und eine Differenz in drei Richtungen davon weniger als 10 mm beträgt, und wobei ein Durchmesser Φ der Stahlkugeln 2 mm bis 6 mm beträgt und ein Gewicht das 0,25 bis 1,5-fache des Gewichts der Nd-Fe-B-Magnetproben beträgt;
b) Starten der Drehung der Trommel (3) und Mischen der Nd-Fe-B-Magnetproben und der Stahlkugeln, wobei die Trommeldrehgeschwindigkeit 5 bis 20 U/min beträgt;
c) Einleiten von Argongas, bis der Druck 3×10⁻¹ Pa bis 6×10⁻¹ Pa beträgt;
d) Starten der Vakuumbeschichtung.

2. Verfahren nach Anspruch 1, wobei das Vakuumbeschichten durch Lichtbogenionenplattieren oder Magnetronsputtern durchgeführt wird.

3. Verfahren nach Anspruch 1, wobei das Vakuumbeschichten Abscheiden von Aluminium auf den Nd-Fe-B-Magnetproben aufweist.

## Revendications

1. Procédé pour le revêtement d'une surface sous vide avec des aimants Nd-Fe-B de petite taille, le procédé comprenant les étapes suivantes :
a) mise à disposition d'un dispositif de revêtement sous vide comprenant :
- une chambre de four sous vide (10) ;
- un tambour (3) avec des parois latérales en mailles, lequel est disposé de façon rotative sur un arbre de rotation (2) à l'intérieur de la chambre de four sous vide (10) ;
- au moins une source cible (5, 6) pour le dépôt sous vide, laquelle est disposée à l'intérieur de la chambre de four sous vide (10) ;
- une entrée de gaz (8) pour le raccordement d'une source d'argon ; et
- une sortie (1) pour le raccordement d'un système de vide ;
b) la disposition d'échantillons d'aimants Nd-Fe-B de petite taille ensemble avec des billes d'acier dans un tambour (3) du dispositif de revêtement sous vide et l'évacuation du tambour (3) jusqu'à ce que la pression soit de 6 x 10⁻³ Pa à 9 x 10⁻³ Pa, où l'épaisseur, la longueur et la largeur des échantillons d'aimants Nd-Fe-B sont inférieures à 15 mm et une différence tri-directionnelle de celles-ci est inférieure à 10 mm, et où un diamètre Φ des billes d'acier est de 2 mm à 6 mm et un poids correspond de 0,25 à 1,5 fois au poids des échantillons d'aimants Nd-Fe-B ;
b) le démarrage de la rotation du tambour (3) et le mélange des échantillons d'aimants Nd-Fe-B et des billes d'acier, la vitesse de rotation du tambour étant de 5 à 20 r/mn ;
c) l'injection de gaz argon jusqu'à ce que la pression soit de 3 x 10⁻¹ Pa à 6 x 10⁻¹ Pa ; et
d) le démarrage du revêtement sous vide.

2. Procédé selon la revendication 1, dans lequel le revêtement sous vide est réalisé par placage ionique à l'arc ou par pulvérisation magnétron.

3. Procédé selon la revendication 1, dans lequel le revêtement sous vide comprend le dépôt d'aluminium sur les échantillons d'aimants Nd-Fe-B.
